# EUROPEAN PATENT SPECIFICATION

(11) **EP 1 301 929 B1**
(45) Date of publication and mention of the grant of the patent: **17.09.2008**
(21) Application number: 01949820.3
(22) Date of filing: 19.07.2001
(51) Int. Cl.: G11C 16/10

(54) **SECURE WRITING OF DATA**
SICHERES SCHREIBEN VON DATEN
ECRITURE SECURISEE DE DONNEES

(30) Priority: 19.07.2000 FR 0009488
(43) Date of publication of application: 16.04.2003
(73) Proprietor: Axalto S.A., 92190 Meudon (FR)
(72) Inventor: MENNECART, José, F-45370 Dry (FR); DELAUNAY, Eric, F-45640 Sandillon (FR)
(74) Representative: Cassagne, Philippe M.J.
(86) International application number: PCT/IB2001/001289
(87) International publication number: WO 2002/009120

(56) References cited:
- FR-A- 2 742 893
- FR-A- 2 754 926
- GB-A- 2 243 230
- US-A- 5 765 211

## Description

### FIELD OF THE INVENTION

The present invention relates to the secure writing of data in a rewritable memory.

It is generally applicable to micro-electronics and more specifically, to the field of electronic memory cards, in particular contact and/or contactless cards as well as wired logic and/or microprocessor cards.

### BACKGROUND OF THE INVENTION

In practice, the electronic memories used in cards are of the EPROM flash, or EEPROM memories ("Electrically Erasable Programmable Read Only Memory"), that is non-volatile and electrically erasable and therefore rewritable memories.

Generally, the establishment of transactions with memory cards, in particular with contactless cards, has to be very fast. Moreover, such transactions must be protected against possible data loss, also known as data corruption, which is liable to occur, for example, on accidental power supply loss when a writing operation is being performed.

Already known methods for writing data in a rewritable memory provide some degree of security in case of data corruption. However, such methods generally require several memory write operations, which increases the writing time two or threefold and increases the risk of memory corruption correspondingly.

See e.g. FR-2.742.893 disclosing a sequential data file containing CRC-fields.

### SUMMARY OF THE INVENTION

It is an object of the invention to allow data to be written relatively fast.

To that end, the invention provides a data processor as defined in claim 1.

The invention allows writing of new data by means of a single operation while the integrity of data that can be read remains guaranteed.

Other features and advantages of this invention will be apparent from the following detailed description of preferred embodiments and the accompanying drawings.

### BRIEF DESCRIPTION OF THE DRAWINGS

- Figure 1 is a schematic drawing of a prior art circular file;
- Figure 2 is a structural view of a circular file according to the invention;
- Figure 3 is a structural view of a record according to the invention, and
- Figure 4 is a flowchart showing the steps of the method for secure writing of data in a rewritable memory according to the invention.

### DETAILED DECSRIPTION

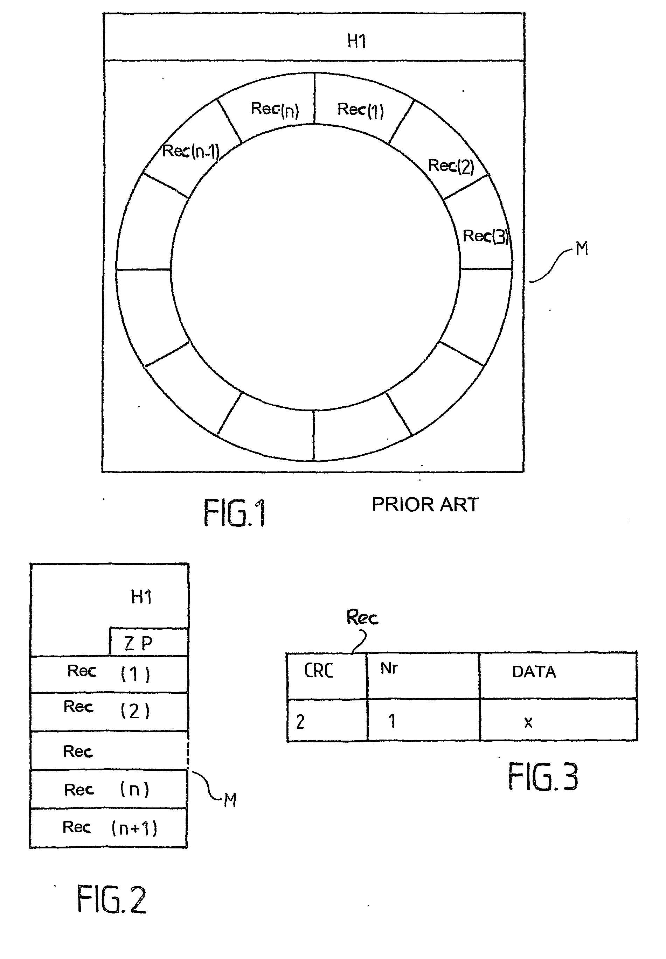

Referring to Figure 1, there is shown an EEPROM or flash EPROM electrically erasable, non-volatile memory, M, controlled by a controller (not shown) which can be a programmed microprocessor.

In practice, memory M and the microprocessor forming the memory controller are carried on the same electronic component, also known as a semiconductor chip.

As usual, memory M is for storing information structured into logical entities controlled by said memory controller. In practice, memory M is segmented into one-byte elements, for example for reading information, and into pages for erasing said information, wherein the writing operation can also be performed on a page by page basis.

The memory controller is adapted, by means of an appropriate program, to organize, that is, to synchronize said logical entities of one or more data types, into pages. Such synchronization is described, for example, in application EP 0 767 742.

By way of example, memory M of Figure 1, which shows the state of the art, is synchronized for a header H1 of a circular file comprising n records organized into a loop with n integers ranging from 1 to n.

The circular file is formed with a header H1 comprising data that are exclusively used by the memory controller and a set of records logically organized into a loop. The records are of fixed length.

For protected writing, that is when the integrity of the data write operation is guaranteed, the write operation is performed each time by means of at least three write operations, a first one for writing in the backup memory area, one for writing to the data area, and one for writing to the backup memory area in order to erase the same.

This state of this art protected writing method is used in order to avoid data loss, in particular, when a card is intentionally or unintentionally withdrawn. However, this method increases the writing time and increases the risk of memory corruption correspondingly.

The present invention remedies this drawback. One embodiment is based on a technique for writing a circular file such as described in reference to Figure 1 through a single write operation for modifying a record in a secure manner by a single write action while preserving protection against withdrawal (card removal). In particular, the state of the art is improved in particular through the use of data and records that are hidden within the circular file, as described in detail below.

Referring to Figure 2, a circular file is illustrated. It comprises n+1 records organized into a loop, where n is an integer. Each record comprises a rank indication, integrity-check data and at least one data value. The integrity-check data may be in the form of, for example, a checksum redundancy code (CRC). The CRC is calculated on the basis of the data values contained in the record.

Let it be assumed that record n is the last record that has correctly been written into the memory M. In that case, records 1 to n are accessible to the user. Record n+1 is hidden from the user. The rank indication and the integrity-check data of each record are also hidden from the user and therefore are only accessible to the memory controller. The memory controller is constituted by the microprocessor having a memory in which a suitable operating system (OS) has been stored. Hidden from the user means that software that is user-related (an application running under the OS) does not have access.

In other words, there has been added to the prior art memory described with reference to Figure 1, a record which is hidden from the user and a secure writing method has been established as described in more detail below. The record that is hidden from the user is the record subsequent to the last record that has correctly been written.

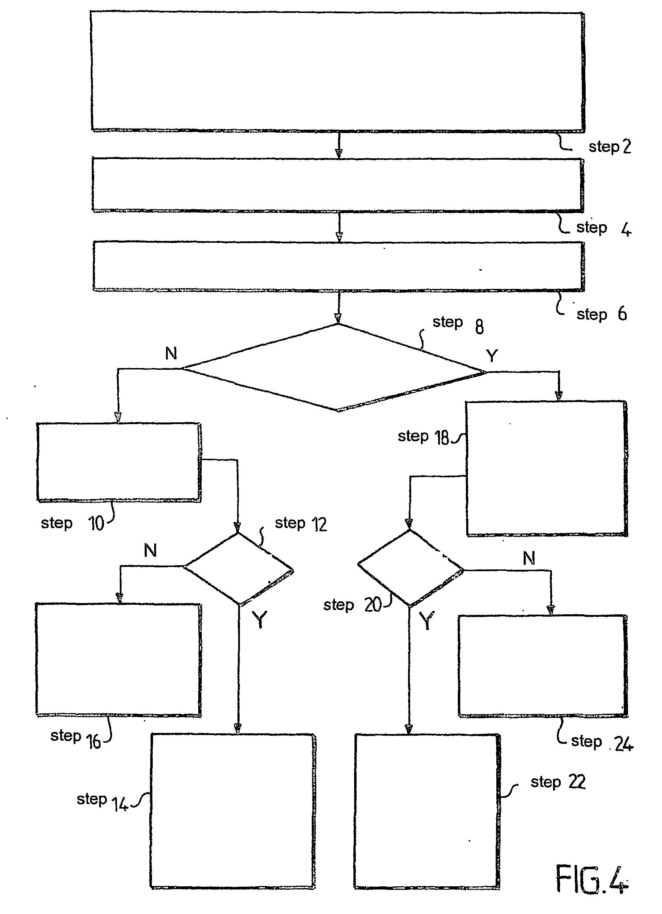

Figure 4 illustrates the secure writing method. In the following description, it is assumed that record n is the last record that has correctly been written. Consequently, record n+1 is the so-called hidden record.

The secure method for writing data into a rewritable memory comprises the following steps.

In a preliminary step, not shown, there is provided a memory M forming a circular file having n+1 records organized into a loop.

In a step 2, when data to be written into the thus defined memory are present, the memory controller selects the circular file.

In step 4, the memory controller searches the current record of highest rank. This is done by means a scan through the memory. As mentioned hereinbefore, each record comprises a rank indication. The rank indication of a record is equal to the rank indication of the record most recently written plus one (1). The first record that is written has, for example, the rank indication one (1). The second record that is written will have the rank indication two (2). The K-th record that is written will have a rank indication that is equal to K modulo n+1.

The memory controller interrogates, as it were, the rank-indication of each record contained in the file. Accordingly, it will find the record having the highest rank indication. This record is the record that has most recently been written into the memory.

In a step 6, the memory controller effects a calculation on the basis of the data values comprised in the record. This calculation is the same as the calculation used to establish the integrity-check data, which is in the form of a CRC.

In a step 8, the memory controller compares the outcome of the calculation effected in step 6 with the CRC. Accordingly, an integrity flag is obtained. This integrity flag indicates whether the data values are corrupted or not.

In case the data values are corrupted (step 10), the memory controller writes the data to be written into the hidden record, which is record n+1.

The memory controller checks the integrity of this write operation (step 12). That is, an operation similar to that explained in step 6 is effected.

In case of success writing (step 14), the memory controller increments the rank of the hidden record by one unit. The hidden record becomes (n+1+1) modulo (n+1) = 1. Records 2 to n+1 are accessible.

In case of unsuccessful writing (step 16), the rank of the hidden record remains unchanged: n+1, so that this record n+1 remains hidden.

If, in step 8, it is established that the data is not corrupted (the integrity flag is good), step 18 is effected. In step 18, the memory controller writes data in the record subsequent to the hidden record at the beginning of the write operation illustrated in Figure 4. The hidden record is n+1 and therefore the memory controller writes in record (n+1+1)mod (n+1)=1. That is, the memory controller replaces record 1 as it was at the being of the write operation by the date to be written.

The integrity of the write operation is checked (step 20) .

In case of successful writing (step 22), the hidden record is record 2 because record 1 is the last record that has been written into successfully. Records 3 to n+2 are accessible to the user.

In case of failure, unsuccessful writing, (step 24), the hidden record is record 1 because record n+1 is the last record that has been written into successfully. Record 1 is subsequent to record n+1 because the records are organized in a circular fashion.

It should be pointed out that the need for a user to have n records is still met. The user will not notice any change in the numbering, since, according to well known means, the operating system matches the actual record numbering with the numbering as seen by a user in a one-to-one relationship according to whether a given record should remain hidden to a user or not.

In practice, in particular, in the case of an electronic purse application, checking the state of the integrity flag according to step 8 consists in checking the immediately preceding record (n) and so on, until the next valid record is reached. The data (for instance, in the case of an electronic purse application, the balance of said purse) in the valid record which is to be used with externally provided data, is then recovered for computing the new balance to be updated into record n+1.

In practice, writing the data (steps 12 and 20) consists in writing in a record having the rank selected according to the present method, the data received and previously saved in a work memory area, and incrementing the record rank.

In summary, when the card customizer creates a file, for example, of n records, the operating system according to the invention consequently generates n+1 records.

The file header H1 is advantageously complemented with a redundancy area ZP, as shown in Figure 2, which is located after header H1 so that the first record begins at the border of a memory page M. Thus, one write operation is needed when updating a record.

Referring to Figure 3, the structure of a record may comprise x bytes allocated for data, x being an integer, two bytes assigned for the integrity-check data, for example a CRC, and one byte allocated to the record rank indication.

Advantageously, the three additional bytes allocated for the integrity flag and the record rank are hidden from the user, that is, are only accessible to the memory controller.

Preferably, the writing method is forced to only accept records with a size of x+3 bytes which is smaller than or equal to the modulus of the size of one memory page. This allows performing all erase and write operations in a single page of the rewritable memory.

In other words, when the customizer wishes to generate a record length of x bytes, the operating system creates a record of x+3 bytes. The three added bytes are for the CRC and the record rank indication.

In the above-mentioned example, the user is also the customizer. According to a modification, when the user is not the card customizer, the user can only modify the contents of records and is unable to create any.

It is possible to create a circular file creation command, "create file", for use by the card customizer to create the file while ensuring that the page border conditions are met. Under such conditions, accordingly, the size of each record is equal to the modulus of the page size.

It should be noted that the command "create file" can be made by the operating system to only accept only records with lengths of 13, 29 or 61 apparent bytes, which corresponds to 16, 32 or 64 actual bytes for the circular file (in this example, it is assumed that the memory page size is 64 bytes). If the size of the memory page is 32 bytes, then the value 61 is invalid.

In practice, when the user creates the record with a length of less than 13 bytes, the record is customized to a length of 16 bytes. Similarly, for a record whose length is less than 29 bytes, the record length is set to 32. The same applies to lengths less than 61 which are then set to 64 bytes. In practice, this setting or "padding" operation is hidden from the user. These customizations ensure that all write operations in an EEPROM memory are performed within a single page.

According to this invention, the file write access time, when a fast transaction is performed, such as by means of a contactless card, is optimized while at the same time preserving writing security. Moreover, since the memory backup area is circular, another advantage of the present invention lies in a smaller wear of the EPROM memory.

The description hereinbefore illustrates the following features of the invention. A data processor comprises a controller for managing a file wherein a plurality of records can be stored in a sequential fashion. The controller checks whether a record has correctly been written into the file. The controller prevents user-related software from reading the record that is subsequent to the last record that has correctly been written.

The record that cannot be accessed by the user-related software is the "hidden record". The hidden record moves, as it were, throughout the file. Its movement is a function of either a successful or an unsuccessful writing. When data needs to be written, it is written into the hidden record. If the writing is successful, the hidden record moves one unit. If the writing is unsuccessful, the hidden record does not move.

## Claims

1. A data processor comprising a controller for managing a file (M) wherein a plurality of records (Rec(1)-Rec(n+1)) can be stored in a sequential fashion, the controller being arranged to check whether a record has correctly been written into the file, **characterized in that** the controller prevents user-related software from reading the record (Rec(n+1)) that is subsequent to the last record (Rec(n)) that has correctly been written.

2. A data processor as claimed in claim 1, wherein, when a new record needs to be written into the file, the controller replaces the record that is subsequent to the last record that has correctly been written by the new record.

3. A method of managing a file (M) wherein a plurality of records (Rec(1)-Rec(n+1)) can be stored in a sequential fashion, the method comprising:
- a verification step (step 8) in which it is checked whether a record has been correctly written into the file; and
- an access-control step (step 14, 16) in which it is prevented that the record that is subsequent to the last record that has correctly been written is read.

4. A computer program product for managing a file (M) wherein a plurality of records (Rec(1)-Rec(n+1)) can be stored in a sequential fashion, the computer program product comprising a set of instructions that, when loaded into a data processor, causes the data processor to carry out:
- a verification step (step 8) in which the data processor checks whether a record has been correctly written into the file; and
- an access-control step (step 14,16) in which the data processor prevents that the record that is subsequent to the last record that has correctly been written is read.

5. The method of claim 3, wherein, for securing the writing in the rewritable memory, said method comprises the steps of:
a) defining a memory comprising a circular file having m records organized into a loop, where m is an integer ranging from 1 to n+1, each record comprising at least one rank, one integrity flag for indicating a bad or good state, and one data value, records of ranks 1 to n being accessible to a user while the record of rank n+1, the integrity flag and the rank of each record are hidden from the user;
b) in the presence of data to be written in the thus defined memory, selecting the circular file;
c) fetching the current record of highest rank m = n+1, and checking the status of its integrity flag;
d) in case the integrity flag is bad, writing the data to be written in the current record of rank m = n+1, and in case of success, incrementing by one unit the rank of the current record m = n+1+1 = 1, which then becomes hidden, so that the records of ranks 2 to n+1 are left to be accessible while in case of failure, not modifying the rank of the current record m = n+1, which remains hidden, while other records of ranks 1 to n remain accessible to the user; and
e) in case the integrity flag is good, writing the data to be written into the record of next rank m = n+1+1 = 1, and in case of success, incrementing by one unit the rank of record m = 1+1 = 2, which becomes hidden, so that records of ranks 3 to n+2 remain accessible, while in case of failure, not modifying the rank of current record m = n+2 which remains hidden, so that records of ranks 2 to n+1 are left accessible to the user.

## Patentansprüche

1. Ein Datenprozessor, der einen Controller zur Verwaltung einer Datei (M) beinhaltet, in der eine Vielzahl von Datensätzen (Datensatz (1) - Datensatz (n+1)) sequentiell gespeichert werden können, wobei der Controller so ausgelegt ist, dass er überprüft, ob ein Datensatz korrekt in die Datei geschrieben wurde, und sich dadurch auszeichnet, dass der Controller verhindert, dass der Datensatz (Datensatz (n+1)) nach dem letzten korrekt geschriebenen Datensatz (Datensatz (n)) von anwenderbezogener Software gelesen wird.

2. Ein Datenprozessor, wie in Anspruch 1 beschrieben, bei dem, wenn ein neuer Datensatz in die Datei geschrieben werden soll, der Controller den Datensatz nach dem letzten korrekt geschriebenen Datensatz durch den neuen Datensatz ersetzt.

3. Ein Verfahren zur Verwaltung einer Datei (M), in der eine Vielzahl von Datensätzen (Datensatz (1) - Datensatz (n+1)) sequentiell gespeichert werden können, wobei das Verfahren folgende Schritte beinhaltet:
- einen Überprüfungsschritt (Schritt 8), bei dem überprüft wird, ob ein Datensatz korrekt in die Datei geschrieben wurde; und
- einen Schritt zur Zugriffskontrolle (Schritt 14, 16), bei dem verhindert wird, dass der Datensatz nach dem letzten korrekt geschriebenen Datensatz gelesen wird.

4. Ein Computerprogramm-Produkt zur Verwaltung einer Datei (M), in der eine Vielzahl von Datensätzen (Datensatz (1) - Datensatz (n+1)) sequentiell gespeichert werden können, wobei das Computerprogramm-Produkt einen Befehlssatz beinhaltet, der, wenn er in den Datenprozessor geladen wird, den Datenprozessor dazu veranlasst, folgende Schritte auszuführen:
- einen Überprüfungsschritt (Schritt 8), bei dem der Datenprozessor überprüft, ob ein Datensatz korrekt in die Datei geschrieben wurde; und
- ein Schritt zur Zugangskontrolle (Schritt 14, 16), bei dem der Datenprozessor verhindert, dass der Datensatz nach dem letzen korrekt geschriebenen Datensatz gelesen wird.

5. Das Verfahren aus Anspruch 3, bei dem zur Sicherung des Schreibvorgangs in den wiederbeschreibbaren Speicher, das genannte Verfahren folgende Schritte beinhaltet:
a) Definition eines Speichers, der eine Ringdatei beinhaltet, bei der m Datensätze in einer Schleife organisiert sind, wobei m eine ganze Zahl zwischen 1 und n+1 ist und jeder Datensatz mindestens einen Rang, ein Integritätssignal zur Anzeige eines schlechten oder guten Zustands und einen Datenwert beinhaltet, und die Datensätze der Ränge 1 bis n für den Anwender zugänglich sind, wohingegen der Datensatz des Rangs n+1, das Integritätssignal und der Rang jedes Datensatzes für den Anwender versteckt sind;
b) bei Anliegen von Daten Schreiben in den so definierten Speicher und Auswahl der Ringdatei;
c) Holen des aktuellen Datensatzes mit dem höchsten Rang m = n+1 und Überprüfung des Zustands seines Integritätssignals.
d) Bei schlechtem Integritätssignal Schreiben der zu schreibenden Daten in den aktuellen Datensatz mit Rang m = n+1 und bei erfolgreichem Schreibvorgang Erhöhung des Rangs des aktuellen Datensatzes m = n+1+n = 1 um eine Einheit, woraufhin der Datensatz versteckt wird, so dass auf die Datensätze der Ränge 2 bis n+1 zugegriffen werden kann, wohingegen bei nicht erfolgreichem Schreibvorgang der Rang des aktuellen Datensatzes m = n+1 nicht verändert wird und der Datensatz versteckt bleibt wohingegen andere Datensätze der Ränge 1 bis n für den Anwender zugänglich bleiben; und
e) Bei gutem Integritätssignal Schreiben der zu schreibenden Daten in den Datensatz des nächsten Rangs m = n+1+1 = 1 und bei erfolgreichem Schreibvorgang Erhöhung des Rangs des Datensatzes m = 1+1 = 2 um eine Einheit, woraufhin der Datensatz versteckt wird, so dass auf die Datensätze der Ränge 3 bis n+2 zugegriffen werden kann wohingegen bei nicht erfolgreichem Schreibvorgang der Rang des aktuellen Datensatzes m = n+2 nicht verändert wird und der Datensatz versteckt bleibt, so dass die Datensätze der Ränge 2 bis n+1 für den Anwender zugänglich bleiben.

## Revendications

1. Un processeur de données comprenant un contrôleur en vue de la gestion d'un fichier (M), sachant que plusieurs enregistrements (Rec (1) - Rec (n+1)) peuvent être sauvegardés de manière séquentielle, le contrôleur étant prévu pour contrôler si un enregistrement a été correctement écrit sur le fichier, **caractérisé en ce que** le contrôleur empêche que le logiciel utilisateur puisse lire l'enregistrement (Rec (n+1) qui suit le dernier enregistrement (Rec (n)) ayant été correctement enregistré.

2. Un processeur de données conformément à la revendication 1, sachant que, lorsqu'un nouvel enregistrement doit être écrit sur le fichier, le contrôleur remplace l'enregistrement qui suit le dernier enregistrement écrit correctement par le nouvel enregistrement.

3. Une méthode de gestion d'un fichier (M), sachant que plusieurs enregistrements (Rec (1) - Rec (n+1)) peuvent être sauvegardés de manière séquentielle, sachant que la méthode comprend :
- une étape de vérification (étape 8) dans laquelle il est contrôlé si un enregistrement a été correctement écrit sur le fichier ; et
- une étape de contrôle d'accès (étapes 14 et 16) dans laquelle il est évité que l'enregistrement qui suit le dernier enregistrement écrit correctement soit lu.

4. Un programme informatique servant à la gestion d'un fichier (M), sachant que plusieurs enregistrements (Rec (1) - Rec (n+1)) peuvent être sauvegardés de manière séquentielle, sachant que le programme informatique comprend un jeu d'instructions qui, lorsqu'elles sont chargées dans le processeur de données, entraînent l'exécution par le processeur de données des actions suivantes :
- une étape de vérification (étape 8) dans laquelle le processeur de données contrôle si un enregistrement a été correctement écrit sur le fichier ; et
- une étape de contrôle d'accès (étapes 14 et 16) dans laquelle le processeur de données évite que l'enregistrement qui suit le dernier enregistrement écrit correctement soit lu.

5. La méthode de la revendication 3, sachant que, pour garantir l'écriture sur la mémoire réinscriptible, ladite méthode comprend les étapes suivantes :
a) définition d'une mémoire comprenant un fichier circulaire ayant m enregistrements organisés dans une boucle, sachant que m est un nombre entier allant de 1 à n+1, chaque enregistrement comprenant au moins un rang, un message d'intégrité pour l'indication d'un bon ou d'un mauvais état et une valeur de données, sachant que les enregistrements de rang 1 à n sont accessibles à un utilisateur tandis que l'enregistrement de rang n+1, le message d'intégrité et le rang de chaque enregistrement sont cachés à l'utilisateur ;
b) en présence de données à inscrire dans la mémoire ainsi définie, sélection du fichier circulaire ;
c) extraction de l'enregistrement actuel du rang le plus élevé m = n+1 et contrôle de l'état de son message d'intégrité ;
d) dans le cas où le message d'intégrité serait mauvais, écriture des données à écrire sur l'enregistrement actuel de rang m = n+1 et, en cas de réussite, incrémentation de une unité du rang de l'enregistrement actuel m = n+1+1 = 1, qui devient alors caché, de sorte que les enregistrements des rangs 2 à n+1 restent accessibles, tandis qu'en cas d'échec, pas de modification du rang de l'enregistrement actuel m = n+1, qui reste caché et que les autres enregistrement des rangs 1 à n restent accessibles à l'utilisateur ; et
e) dans le cas où le message d'intégrité est bon, écriture des données à écrire sur l'enregistrement de rang suivant m = n+1+1 = 1 et, en cas de réussite, incrémentation de une unité du rang de l'enregistrement m=1+1 =2, qui devient alors caché, de sorte que les enregistrements des rangs 3 à n+2 restent accessibles, tandis qu'en cas d'échec, pas de modification du rang de l'enregistrement actuel m = n+2, qui reste caché, de sorte que les enregistrement des rangs 2 à n+1 restent accessibles à l'utilisateur.
